(19) Europäisches Patentamt
European Patent Office
Office européen des brevets

(11) **EP 2 738 818 A2**

(12) **EUROPEAN PATENT APPLICATION**

(43) Date of publication:
04.06.2014 Bulletin 2014/23

(51) Int Cl.:
*H01L 31/032* (2006.01)

(21) Application number: 13185339.2

(22) Date of filing: 20.09.2013

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: 23.11.2012 US 201261729513 P
10.01.2013 US 201361751219 P

(71) Applicant: **Samsung SDI Co., Ltd.
Yongin-si, Gyeonggi-do (KR)**

(72) Inventors:
• **Huh, Kwang-Soo
331-300 (KR)**
• **Lee, Dong-Ho
Gyeonggi-do (KR)**
• **Shin, Jae-Ho
336-840 (KR)**

(74) Representative: **Mounteney, Simon James
Marks & Clerk LLP
90 Long Acre
London
WC2E 9RA (GB)**

(54) **Solar call and method of manufacturing the same**

(57) A solar cell and a method of manufacturing the same are provided. The solar cell includes: a rear electrode layer disposed on a substrate; a light-absorption layer disposed on the rear electrode layer and including Cu, In, Ga, Se, and S;, wherein the light-absorption layer includes a depletion region ranging from a surface thereof to a depth t, and an average S/(Se+S) mole ratio in the depletion region is from about 0.10 to about 0.30. The content of S in the light-absorption layer of the solar cell is controlled to have an increased surface energy band gap (Eg) on the surface of the light-absorption layer, which improves a resistance to thermal degradation of the solar cell.

FIG. 1

EP 2 738 818 A2

**Description**

[Technical Field]

One or more embodiments of the present invention relate to a solar cell, a method of manufacturing the same, and more particularly, to a solar cell around which a surface of a light-absorption layer has improved resistance to thermal degradation, and a method of manufacturing the solar cell.

[Prior Art]

Recently, amid concerns about the depletion of existing energy resources, such as oil or coal, there has been a rising interest in alternative energy. Of alternative energy resources solar cells that convert solar energy directly into electric energy by using semiconductor devices are drawing attention as a next-generation cell.

A solar cell including a basic unit as a diode with a pn function may be classified depending on a material of a light-absorption layer therein.

For example, a solar cell using silicon in the light-absorption layer may be classified as either a crystalline wafer-type solar cell (monocrystalline or polycrystalline), or a thin film type (amorphous or polycrystalline) solar cell. Other representative solar cells are, for example, compound thin film type solar cells including a copper-indium-selenide ($CuInSe_2$, CIS-based) or cadmium-tellurium (CdTe)-based light-absorption layer, Group III-V solar cells, dye-sensitive solar cells, and organic solar cells.

Of these solar cells, the solar cell including a CIS-based light-absorption layer has an energy band gap ($E_g$) of about 1.04eV, a high short-circuit current, and a low open-circuit voltage, and thus have a low efficiency. Accordingly, there has been much research into partial substitution of Se with S for increasing the open-circuit voltage of the solar cell while maintaining adhesion between the CIS-based light-absorption layer and a rear electrode layer.

However, addition of excess S may cause severe thermal degradation around a surface of a light-absorption layer of the solar cell even from low-temperature heat, and thus there still are demands for a solar cell with improved resistance to thermal degradation and a method of manufacturing the solar cell.

[Disclosure of the Invention]

[Technical Goal of the Invention]

One or more embodiments of the present invention include a solar cell that has an improved open-circuit voltage while maintaining adhesion between a light-absorption layer and a rear-electrode layer thereof, and that has improved resistance to thermal degradation of around a surface of the light-absorption layer.

One or more embodiments of the present invention provide a method of manufacturing the solar cell.

[Means for Achieving Technical Goal]

The present invention provides a solar cell as claimed in any of claims 1 to 11 and a process for manufacturing said solar cell as claimed in claim 12.

According to one or more embodiments of the present invention, a solar cell includes:

a rear electrode layer disposed on a substrate;
a light-absorption layer disposed on the rear electrode layer and including Cu, In, Ga, Se, and S;
a buffer layer disposed on the light-absorption layer; and
a transmissive electrode layer disposed on the buffer layer,
wherein the light-absorption layer includes a depletion region ranging from a surface thereof to a depth t, and an average S/(Se+S) mole ratio in the depletion region is from about 0.10 to about 0.30.

The depth t may preferably be no greater than about 400 nm.

The depletion region of the light-absorption layer may have an average composition represented by Formula 1 below:

$$<\text{Formula 1}> \qquad Cu(In_{1-x}Ga_x)(Se_{1-y}S_y)_2$$

In Formula 1, x is $0.01 \leq x \leq 0.25$, and y is $0.1 \leq y \leq 0.30$.

According to one or more embodiments of the present invention, a method of manufacturing a solar cell includes:

preparing a substrate with a rear electrode layer thereon;
forming a light-absorption layer including Cu, In, Ga, Se, and S on the substrate with the rear electrode layer;
forming a buffer layer on the light-absorption layer; and
forming a transmissive electrode layer on the buffer layer,
wherein the forming of the light-absorption layer involves thermally treating a metal precursor layer in a $H_2Se$ atmosphere at a temperature of from about 400°C to about 480°C for selenization, and thermally treating the selenized metal precursor in a $H_2S$ atmosphere at a temperature of from about 500°C to about 600°C for about 30 minutes to about 60 minutes for sulfurization.

In the method, the light-absorption layer of the solar cell may include a depletion region ranging from a surface thereof to a depth t, and an average S/(Se+S) mole ratio in the depletion region may be from about 0.10 to about 0.30.

[Effect of the Invention]

As described above, according to the one or more embodiments of the present invention, a light-absorption layer includes a depletion region ranging from a surface thereof to a depth t, wherein an average S/(Se+S) mole ratio in the depletion region is in the range from about 0.10 to about 0.30. A solar cell including the light-absorption layer may have an improved open-circuit voltage while maintaining adhesion between the light-absorption layer and a rear electrode layer, and may have improved resistance to thermal degradation.

[Brief Description of the Drawings]

FIG. 1 is a schematic view of a solar cell according to an embodiment of the present invention.
FIG. 2 is a Raman spectrum of a depletion region of a light-absorption layer in a solar cell of Example 1, the depletion region ranging from a surface of the light-absorption layer to a depth of 300 nm.
FIG. 3 is a depth profile of CIGS in the depletion region of the light-absorption layer in the solar cell of Example 1, the depletion region ranging from the surface to the depth of 300 nm, obtained by secondary ion mass spectrometry (SIMS).
FIG 4 is a graph representing results of thermal degradation with respect to S/(Se+S) mole ratio in solar cells of Examples 1 to 3 and Comparative Examples 1 to 6 after each solar cell was left in a 160°C oven for 15 minutes.
FIG. 5 illustrates Arrehnius plots of the solar cell of Example 1 before and after being left in 160°C oven for 15 minutes, obtained by admittance spectroscopy.
FIG. 6 illustrates Arrehnius plots of the solar cell of Comparative Example 3 before and after being left in 160°C oven for 15 minutes, obtained by admittance spectroscopy.

[Description of Embodiments]

The present invention will now be described more fully with reference to the accompanying drawings, in which embodiments of a solar cell and a method of manufacturing the same are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art. In the drawings, elements are exaggerated, omitted, or schematically illustrated for clarity. It will also be understood that when a layer is referred to as being "on" another layer or substrate, it can be directly on the other layer or substrate, or intervening layers may also be present.

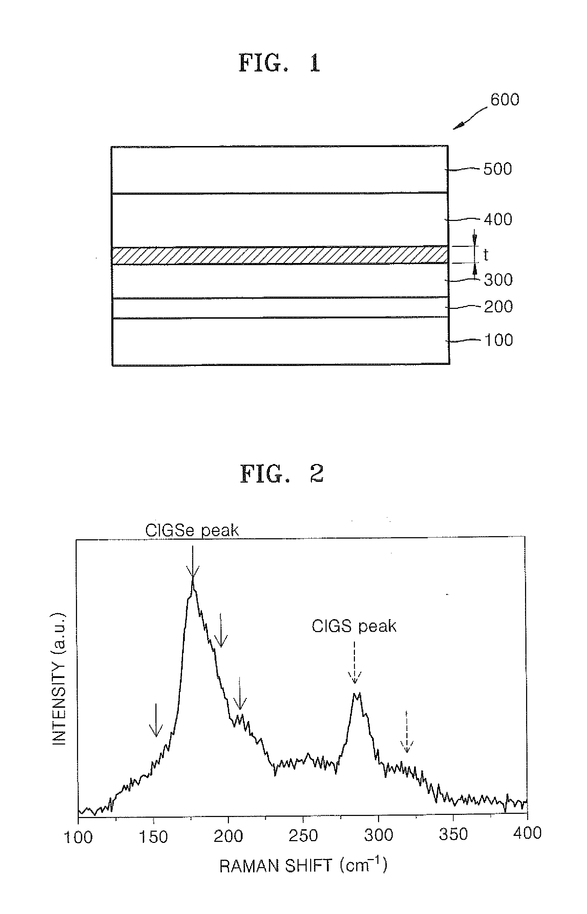

FIG. 1 is a schematic view of a solar cell 600 according to an embodiment of the present invention.
Referring to FIG. 1, the solar cell 600 includes a rear electrode layer 200 disposed on a substrate 100, a light-absorption layer 300 disposed on the rear electrode layer 200, a buffer layer 400 disposed on the light-absorption layer 300, and a transmissive electrode layer 500 disposed on the buffer layer 400.
The substrate 100 may include a glass, ceramic, stainless steel, metal, or polymer substrate. For example, the glass substrate may be a sodalime glass or a high-strained point soda glass.
The glass substrate may be formed of, for example, low-iron tempered glass. The low-iron sodalime glass may elute sodium (Na) ions at a process temperature of, for example, over about 500°C, thereby further improve efficiency of the light-absorption layer 300.
The ceramic substrate may be, for example, an alumina substrate. The metal substrate may be a copper tape or the like. The polymer substrate may be a polyimide substrate or the like.
The rear electrode layer 200 may include molybdenum (Mo), aluminum (Al), copper (Cu), or an alloy thereof.

The rear electrode layer 200 may be formed of a metal material with high conductivity and high light reflectivity to be able to collect charges generated due to a photoelectric effect and to reflect light passing through the light-absorption layer 300 to be reabsorbed by the light-absorption layer 300. For example, the rear electrode layer 200 may include molybdenum (Mo), in consideration of high conductivity, ohmic contact with the light-absorption layer 300, and high-temperature stability in a selenium (Se) atmosphere. The rear electrode layer 200 may have a thickness of from about 200 nm to about 500 nm.

The rear electrode layer 200 may be doped with alkali ions, for example, Na ions. For example, during growing of the light-absorption layer 300, the alkali ions doped on the rear electrode layer 200 may be incorporated into the light-absorption layer 300, and thus provide a structurally advantageous effect and high conductivity to the light-absorption layer 300. Accordingly, the solar cell 600 may have an increased open-circuit voltage $V_{oc}$ and an increased efficiency. The rear electrode layer 200 may be formed as a multi-layer to ensure adhesion to the substrate 100 and satisfactory resistance characteristics of the rear electrode layer 200.

The light-absorption layer 300, as a p-type semiconductor layer including a copper-indium-gallium-selenide $(Cu(In, Ga)Se_2, CIGS)$-based compound obtained by substituting part of indium (In) in a copper-indium-selenium based compound with an amount of gallium (Ga) and part of selenium (Se) with an amount of S, absorbs incident solar light.

The light-absorption layer 300 may form a depletion region ranging from a surface thereof to a depth t. An average S/(Se+S) mole ratio in the depletion region may be from about 0.1 to about 0.30, and in some embodiments, from about 0.10 to about 0.27, and in some other embodiments, preferably 0.10 to about 0.30, from about 0.12 to about 0.27, from about 0.10 to about 0.25, from about 0.14 to about 0.25, from about 0.15 to about 0.25, from about 0.16 to about 0.25 or from about 0.20 to about 0.25.

The S/(Se+S) mole ratio may be highest on the surface of the light-absorption layer 300, and may gradually reduce toward the depletion region away from the surface.

The depth t may vary depending on the content of S. The depth t may be no greater than about 400 nm, for example, no greater than about 300 nm, optionally 25 to 350 nm, optionally 50 to 325 nm, optionally 250 to 325 nm.

The light-absorption layer 300 may include a depletion region (denoted by slash lines) ranging from a surface thereof to a depth t. When the depletion region includes excess substituted S, a deep defect may be caused when external heat is applied to the depletion region. This may hinder collecting carriers and cause severe thermal degradation.

When the average S/(Se+S) mole ratio in the depletion region (denoted by slash lines) is within these range by controlling the content of S, adhesion between the light-absorption layer 300 and the rear electrode layer 200 may be maintained, and allows the rear electrode layer 200 to have a required minimum thickness or greater thickness for adhesion between the light-absorption layer 300 and the rear electrode layer 200. The light-absorption layer 300 may also have an increased surface energy band gap $(E_g)$ and an improved open-circuit voltage $V_{oc}$. Accordingly, the solar cell 600 including the light-absorption layer 300 may have improved resistance to thermal degradation.

The depletion region (denoted by slash lines) of the light-absorption layer 300 may have an average composition represented by Formula 1 below:

$$<\text{Formula 1}> \qquad Cu(In_{1-x}Ga_x)(Se_{1-y}S_y)_2$$

In Formula 1,
$0.01 \leq x \leq 0.25$, and $0.1 \leq y \leq 0.30$.

In an embodiment of the present invention, the depletion region of the light-absorption layer 300, an average S/(Se+S) mole ratio may be from about 0.1 to about 0.30, and an average Ga/(In+Ga) mole ratio may be from about 0.01 to about 0.25. In an embodiment of the present invention, an average S/(Se+S) mole ratio is preferably from about 0.12 to about 0.27, from about 0.10 to about 0.25, from about 0.14 to about 0.25, from about 0.15 to about 0.25, from about 0.16 to about 0.25 or from about 0.20 to about 0.25. In an embodiment of the present invention, an average Ga/(In+Ga) mole ratio is preferably from about 0.01 to about 0.20.

For example, when the average S/(Se+S) mole ratio in the depletion region of the light-absorption layer 400 is from about 0.1 to about 0.27, the average Ga/(In+Ga) mole ratio may be from about 0.01 to about 0.27. In some other embodiments, when the average S/(Se+S) mole ratio in the depletion region of the light-absorption layer 400 is from about 0.1 to about 0.25, the average Ga/(In+Ga) mole ratio may be from about 0.01 to about 0.2.

The light-absorption layer 300 may preferably have a thickness of from between 0.7 $\mu$m to about 2.5 $\mu$m in thickness, optionally 0.7 $\mu$m to about 2 $\mu$m and optionally 1.0 $\mu$m to about 2 $\mu$m. The light-absorption layer 300 may have any thickness within this range.

The buffer layer 400 may include CdS, ZnS, ZnO, ZnSe, $In_2S_3$, $Zn_xMg_{(1x)}O$ (where $0 < x < 1$), Zn(S, O), or Zn(S, O, OH). The buffer layer 400 may reduce a band gap difference between the light-absorption layer 300, and the transmissive electrode layer 500, which will be described later, and may less likely cause recombination of electrons and holes in an interface between the light-absorption layer 300 and the transmissive electrode layer 500.

The transmissive electrode layer 500 may include ZnO, ZnO:Al, ZnO:B, indium tin oxide (ITO), or indium zinc oxide (IZO). The transmissive electrode layer 500 may be formed of a transparent conductive material and capture charges generated due to a photoelectric effect.

Although not illustrated in FIG. 1, an upper surface of the transmissive electrode layer 500 may be textured to reduce reflection of incident solar light and increase light absorption into the light-absorption layer 300.

The present invention also provides a solar cell as defined above, wherein the solar cell is produced by a process comprising the steps of:

preparing a substrate with a rear electrode layer thereon;
forming a light-absorption layer including Cu, In, Ga, Se, and S on the substrate with the rear electrode layer;
wherein the forming of the light-absorption layer comprises thermally treating a selenized metal precursor in a $H_2S$ atmosphere at a temperature of from about 500°C to about 600°C for 25 minutes to about 80 minutes, optionally about 30 minutes to about 70 minutes and optionally about 30 minutes to about 60 minutes for sulfurization.

In an embodiment of the present invention, the sulfurization step is carried out at a temperature of from about 525°C to about 575°C, optionally from about 540°C to about 560°C.

In an embodiment of the present invention, the selenized metal precursor is formed by thermally treating a metal precursor layer in a H2Se atmosphere at a temperature of from about 400°C to about 480°C for selenization, optionally from about 410°C to about 450°C, for 5 minutes to about 40 minutes, optionally about 15 minutes to about 25 minutes.

The present invention also provides a process as defined above.

According to another embodiment of the present invention, a method of manufacturing a solar cell includes: preparing a substrate with a rear electrode layer thereon; forming a light-absorption layer including Cu, In, Ga, Se, and S on the substrate with the rear electrode layer; forming a buffer layer on the light-absorption layer; and forming a transmissive electrode layer on the buffer layer, wherein the forming of the light-absorption layer involves thermally treating a metal precursor layer in a $H_2Se$ atmosphere at a temperature of from about 400°C to about 480°C for selenization, and thermally treating the selenized metal precursor in a $H_2S$ atmosphere at a temperature of from about 500°C to about 600°C for about 30 minutes to about 60 minutes for sulfurization.

First, a substrate 100 with a rear electrode layer 200 is prepared. The rear electrode layer 200 may be formed, for example, by coating a conductive paste on the substrate 100 and thermally treating the same, or by plating. For example, the rear electrode layer 200 may be formed by sputtering using a molybdenum (Mo) target.

Subsequently, the light-absorption layer 300 including Cu, In, Ga, Se, and S is formed on the substrate 100 with the rear electrode layer 200 formed thereon. The light-absorption layer 300 may formed by co-evaporation in which copper (Cu), indium (In), gallium (Ga), and selenium (Se) are placed in an electric furnace in a vacuum chamber and then heated to evaporate

The light-absorption layer 300 may be formed by sputtering/selenization. According to this method, a CIG-based metal precursor layer is formed on the rear electrode layer 200 using copper (Cu), indium (In), and gallium (Ga) metal targets and/or an alloy target thereof, and then thermally treated in a $H_2Se$ gas atmosphere to form a selenized metal precursor layer, which is then further thermally treated in a $H_2S$ gas atmosphere to form the light-absorption layer 300 including Cu, In, Ga, Se, and S. In some embodiments, the light-absorption layer 300 may be formed by electro-deposition, molecular organic chemical vapor deposition (MOCVD), or the like.

For example, forming the light-absorption layer 300 by sputtering/selenization may involve thermally treating a metal precursor layer in a $H_2Se$ atmosphere at a temperature of from about 400°C to about 480°C for selenization, and thermally treating the selenized metal precursor layer in a $H_2S$ atmosphere at a temperature of from about 500°C to about 600°C for about 30 minutes to about 60 minutes for sulfurization.

In a preferred embodiment of the present invention the sulfurization step is carried out at a temperature of from about 525°C to about 575°C, preferably from about 540°C to about 560°C for about 30 minutes to about 70 minutes, preferably about 30 minutes to about 60 minutes.

When the temperature and time for sulfurizing the light-absorption layer 300 are within these ranges, the average S/(Se+S) mole ratio in the depletion region (denoted by slash lines) of the light-absorption layer 300 ranging from the surface to the depth t may be from about 0.10 to about 0.25.

The S/(Se+S) mole ratio may be highest on the surface of the light-absorption layer 300, and may gradually reduce toward the depletion region away from the surface.

The depth t may vary depending on the content of S. The depth t may be no greater than about 400 nm, for example, no greater than about 300 nm.

When the average S/(Se+S) mole ratio in the depletion region (denoted by slash lines) is within these range by controlling the content of S, adhesion between the light-absorption layer 300 and the rear electrode layer 200 may be maintained, and allows the rear electrode layer 200 to have a required minimum thickness or greater thickness for adhesion between the light-absorption layer 300 and the rear electrode layer 200. The light-absorption layer 300 may also have an increased surface energy band gap ($E_g$) and an improved open-circuit voltage $V_{oc}$. Accordingly, the solar cell 600 including the light-absorption layer 300 may have improved resistance to thermal degradation.

The depletion region of the light-absorption layer 300 may have an average composition represented by Formula 1 above.

The light-absorption layer 300 may have a thickness of from about 0.7 $\mu$m to about 2 $\mu$m. The light-absorption layer 300 may have any thicknesses within this range.

Subsequently, the buffer layer 400 is formed on the light-absorption layer 300. The buffer layer 400 may reduce a band gap difference between the p-type light-absorption layer 300 and the n-type transmissive electrode layer 500, and suppresses recombination of electrons and holes in an interface between the light-absorption layer 300 and the transmissive electrode layer 500. The buffer layer 400 may be formed by chemical bath deposition (CBD), atomic layer deposition (ALD), or ion lay gas reaction (ILGAR).

Next, the transmissive electrode layer 500 is formed on the buffer layer 400. The transmissive electrode layer 500 may be formed, for example, by metalorganic chemical vapor deposition (MOCVD), low-pressure chemical vapor deposition (LPCVD), or sputtering.

Although not illustrated, a top surface of the transmissive electrode layer 500 may be processed by texturing. Texturing is to form an uneven pattern on a surface by using a physical or chemical method. When the top surface of the transmissive electrode layer 500 is processed to be rough by texturing, reflection of incident light may reduced so that the transmissive electrode layer 500 may capture a larger amount of light. This may reduce light loss.

Hereinafter, one or more embodiments of the present invention will be described in further detail with reference to the following examples. These examples are not intended to limit the purpose and scope of the one or more embodiments of the present invention.

[Examples]

**Example** 1

A sodalime glass substrate of a thickness of about 1.8 mm with a Mo rear electrode layer was prepared. Sputtering was performed using a CuGa target and an In target to form a metal precursor layer on the sodalime glass substrate with the Mo rear electrode layer. The metal precursor layer was subjected to selenization in a $H_2Se$ atmosphere at about 420°C for about 20 minutes, followed by heat treatment in a $H_2S$ atmosphere at about 550°C for about 60 minutes for sulfurization to form a light-absorption layer including Cu, In, Ga, Se, and S.

The light-absorption layer formed a depletion region to a depth of about 300 nm from a surface thereof, wherein an average S/(Se+S) mole ratio in the depletion region was about 0.25. The light-absorption layer had a thickness of about 1.8 $\mu$m.

A ZnS buffer layer was formed on the light-absorption layer by chemical bath deposition (CBD) using ammonia water ($NH_4OH$), zinc sulfide hydrate ($ZnSO_4 \cdot 7H_2O$), and thiourea ($CS(NH_2)_2$). A ZnO transmissive electrode layer was formed on the buffer layer by metal organic chemical vapor deposition (MOCVD), thereby manufacturing a solar cell.

**Example 2**

A sodalime glass substrate of a thickness of about 1.8 mm with a Mo rear electrode layer was prepared. Sputtering was performed using a CuGa target and an In target to form a metal precursor layer on the sodalime glass substrate with the Mo rear electrode layer. The metal precursor layer was subjected to selenization in a $H_2Se$ atmosphere at about 420°C for about 20 minutes, followed by heat treatment in a $H_2S$ atmosphere at about 550°C for about 50 minutes for sulfurization to form a light-absorption layer including Cu, In, Ga, Se, and S.

The light-absorption layer formed a depletion region to a depth of about 300 nm from a surface thereof, wherein an average S/(Se+S) mole ratio in the depletion region was about 0.22. The light-absorption layer had a thickness of about 1.8 $\mu$m.

A ZnS buffer layer was formed on the light-absorption layer by chemical bath deposition (CBD) using ammonia water ($NH_4OH$), zinc sulfide hydrate ($ZnSO_4 \cdot 7H_2O$), and thiourea ($CS(NH_2)_2$). A ZnO transmissive electrode layer was formed on the buffer layer by metal organic chemical vapor deposition (MOCVD), thereby manufacturing a solar cell.

**Example** 3

A sodalime glass substrate of a thickness of about 1.8 mm with a Mo rear electrode layer was prepared. Sputtering was performed using a CuGa target and an In target to form a metal precursor layer on the sodalime glass substrate with the Mo rear electrode layer. The metal precursor layer was subjected to selenization in a $H_2Se$ atmosphere at about 420°C for about 20 minutes, followed by heat treatment in a $H_2S$ atmosphere at about 550°C for about 30 minutes for sulfurization to form a light-absorption layer including Cu, In, Ga, Se, and S.

The light-absorption layer formed a depletion region to a depth of about 300 nm from a surface thereof, wherein an average S/(Se+S) mole ratio in the depletion region was about 0.16. The light-absorption layer had a thickness of about 1.8 $\mu$m.

A ZnS buffer layer was formed on the light-absorption layer by chemical bath deposition (CBD) using ammonia water ($NH_4OH$), zinc sulfide hydrate ($ZnSO_4 \cdot 7H_2O$), and thiourea ($CS(NH_2)_2$). A ZnO transmissive electrode layer was formed on the buffer layer by metal organic chemical vapor deposition (MOCVD), thereby manufacturing a solar cell.

## Comparative Example 1

A sodalime glass substrate of a thickness of about 1.8 mm with a Mo rear electrode layer was prepared. Sputtering was performed using a CuGa target and an In target to form a metal precursor layer on the sodalime glass substrate with the Mo rear electrode layer. The metal precursor layer was subjected to selenization in a $H_2Se$ atmosphere at about 420°C for about 20 minutes, followed by heat treatment in a $H_2S$ atmosphere at about 550°C for about 20 minutes for sulfurization to form a light-absorption layer including Cu, In, Ga, Se, and S.

The light-absorption layer formed a depletion region to a depth of about 300 nm from a surface thereof, wherein an average S/(Se+S) mole ratio in the depletion region was about 0.08. The light-absorption layer had a thickness of about 1.8 $\mu$m.

A ZnS buffer layer was formed on the light-absorption layer by chemical bath deposition (CBD) using ammonia water ($NH_4OH$), zinc sulfide hydrate ($ZnSO_4 \cdot 7H_2O$), and thiourea ($CS(NH_2)_2$). A ZnO transmissive electrode layer was formed on the buffer layer by metal organic chemical vapor deposition (MOCVD), thereby manufacturing a solar cell.

## Comparative Example 2

A sodalime glass substrate of a thickness of about 1.8 mm with a Mo rear electrode layer was prepared. Sputtering was performed using a CuGa target and an In target to form a metal precursor layer on the sodalime glass substrate with the Mo rear electrode layer. The metal precursor layer was subjected to selenization in a $H_2Se$ atmosphere at about 420°C for about 20 minutes, followed by heat treatment in a $H_2S$ atmosphere at about 550°C for about 110 minutes for sulfurization to form a light-absorption layer including Cu, In, Ga, Se, and S.

The light-absorption layer formed a depletion region to a depth of about 300 nm from a surface thereof, wherein an average S/(Se+S) mole ratio in the depletion region was about 0.38. The light-absorption layer had a thickness of about 1.8 $\mu$m.

A ZnS buffer layer was formed on the light-absorption layer by chemical bath deposition (CBD) using ammonia water ($NH_4OH$), zinc sulfide hydrate ($ZnSO_4 \cdot 7H_2O$), and thiourea ($CS(NH_2)_2$). A ZnO transmissive electrode layer was formed on the buffer layer by metal organic chemical vapor deposition (MOCVD), thereby manufacturing a solar cell.

## Comparative Example 3

A sodalime glass substrate of a thickness of about 1.8 mm with a Mo rear electrode layer was prepared. Sputtering was performed using a CuGa target and an In target to form a metal precursor layer on the sodalime glass substrate with the Mo rear electrode layer. The metal precursor layer was subjected to selenization in a $H_2Se$ atmosphere at about 420°C for about 20 minutes, followed by heat treatment in a $H_2S$ atmosphere at about 550°C for about 90 minutes for sulfurization to form a light-absorption layer including Cu, In, Ga, Se, and S.

The light-absorption layer formed a depletion region to a depth of about 300 nm from a surface thereof, wherein an average S/(Se+S) mole ratio in the depletion region was about 0.34. The light-absorption layer had a thickness of about 1.8 $\mu$m.

A ZnS buffer layer was formed on the light-absorption layer by chemical bath deposition (CBD) using ammonia water ($NH_4OH$), zinc sulfide hydrate ($ZnSO_4 \cdot 7H_2O$), and thiourea ($CS(NH_2)_2$). A ZnO transmissive electrode layer was formed on the buffer layer by metal organic chemical vapor deposition (MOCVD), thereby manufacturing a solar cell.

## Comparative Example 4

A sodalime glass substrate of a thickness of about 1.8 mm with a Mo rear electrode layer was prepared. Sputtering was performed using a CuGa target and an In target to form a metal precursor layer on the sodalime glass substrate with the Mo rear electrode layer. The metal precursor layer was subjected to selenization in a $H_2Se$ atmosphere at about 420°C for about 15 minutes, followed by heat treatment in a $H_2S$ atmosphere at about 550°C for about 90 minutes for sulfurization to form a light-absorption layer including Cu, In, Ga, Se, and S.

The light-absorption layer formed a depletion region to a depth of about 300 nm from a surface thereof, wherein an average S/(Se+S) mole ratio in the depletion region was about 0.35. The light-absorption layer had a thickness of about 1.8 $\mu$m.

A ZnS buffer layer was formed on the light-absorption layer by chemical bath deposition (CBD) using ammonia water ($NH_4OH$), zinc sulfide hydrate ($ZnSO_4 \cdot 7H_2O$), and thiourea ($CS(NH_2)_2$). A ZnO transmissive electrode layer was formed on the buffer layer by metal organic chemical vapor deposition (MOCVD), thereby manufacturing a solar cell.

## Comparative Example 5

A sodalime glass substrate of a thickness of about 1.8 mm with a Mo rear electrode layer was prepared. Sputtering was performed using a CuGa target and an In target to form a metal precursor layer on the sodalime glass substrate with the Mo rear electrode layer. The metal precursor layer was subjected to selenization in a $H_2Se$ atmosphere at about 420°C for about 20 minutes, followed by heat treatment in a $H_2S$ atmosphere at about 550°C for about 100 minutes for sulfurization to form a light-absorption layer including Cu, In, Ga, Se, and S.

The light-absorption layer formed a depletion region to a depth of about 300 nm from a surface thereof, wherein an average S/(Se+S) mole ratio in the depletion region was about 0.37. The light-absorption layer had a thickness of about 1.8 $\mu$m.

A ZnS buffer layer was formed on the light-absorption layer by chemical bath deposition (CBD) using ammonia water ($NH_4OH$), zinc sulfide hydrate ($ZnSO_4 \cdot 7H_2O$), and thiourea ($CS(NH_2)_2$). A ZnO transmissive electrode layer was formed on the buffer layer by metal organic chemical vapor deposition (MOCVD), thereby manufacturing a solar cell.

## Comparative Example 6

A sodalime glass substrate of a thickness of about 1.8 mm with a Mo rear electrode layer was prepared. Sputtering was performed using a CuGa target and an In target to form a metal precursor layer on the sodalime glass substrate with the Mo rear electrode layer. The metal precursor layer was subjected to selenization in a $H_2Se$ atmosphere at about 420°C for about 20 minutes, followed by heat treatment in a $H_2S$ atmosphere at about 550°C for about 80 minutes for sulfurization to form a light-absorption layer including Cu, In, Ga, Se, and S.

The light-absorption layer formed a depletion region to a depth of about 300 nm from a surface thereof, wherein an average S/(Se+S) mole ratio in the depletion region was about 0.32. The light-absorption layer had a thickness of about 1.8 $\mu$m.

A ZnS buffer layer was formed on the light-absorption layer by chemical bath deposition (CBD) using ammonia water ($NH_4OH$), zinc sulfide hydrate ($ZnSO_4 \cdot 7H_2O$), and thiourea ($CS(NH_2)_2$). A ZnO transmissive electrode layer was formed on the buffer layer by metal organic chemical vapor deposition (MOCVD), thereby manufacturing a solar cell.

## Evaluation Example 1: Raman Spectrometry Test

The solar cell of Example 1 was tested using a Raman spectrometer (available from Renishaw), in which the (depletion) region of the light-absorption layer ranging from the surface thereof to the depth of about 300 nm was irradiated with laser light of about 633 nm. The results are shown in FIG. 2.

Referring to FIG. 2, CIGSe peaks appear in the range of 150cm$^{-1}$ to 210cm$^{-1}$, and CIGS peaks appear in the range of 275cm$^{-1}$ to 340cm$^{-1}$. A S/(Se+S) mole ratio was calculated using Equation 1 below.

$$< Equation\ 1 > \qquad S/(Se+S)\ mole\ ratio = [(Area\ of\ CIGS\ peaks)/(Area\ of\ CIGSe\ peaks + Area\ of\ CIGS\ peaks)]$$

Referring to FIG. 2, the depletion region of the light-absorption layer in the solar cell of Example 1, the depletion region ranging from the surface of the light-absorption layer to the depth of about 2 to 300 nm, is found to have a S/(Se+S) mole ratio of about 0.25.

## Evaluation Example 2: Secondary Ion Mass Spectrometry (SIMS) Test

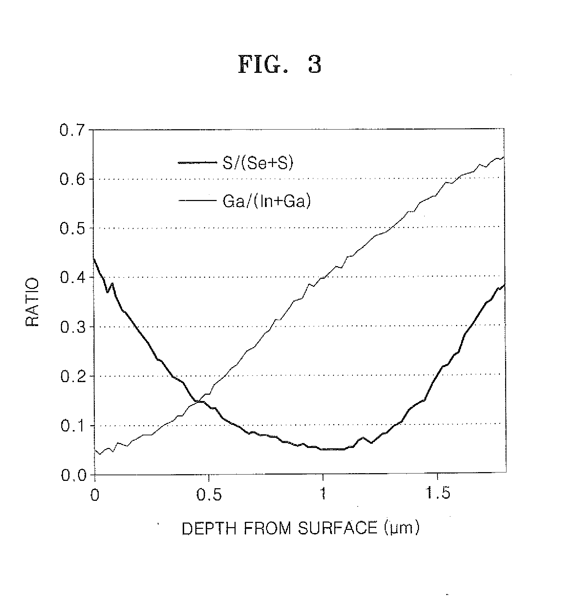

The depletion region of the light-absorption layer in the solar cell of Example 1, the depletion region ranging from the surface of the light-absorption layer to the depth of about 300 nm, was analyzed by secondary ion mass spectrometry (SIMS) using an analyzer (IMS-6f Magnetic Sector SIMS, available from CAMECA). The results are shown in FIG. 3.

Experimental conditions for the SIMS measurement were as follows.
Primary ion conditions: Cs$^+$ ions, 5keV, about 80nA

Irradiation area: Raster Size (about $200\mu m\times200\mu m$)
Analysis area: about $30\mu m$ ($\Phi$)
Polarity of secondary ions: Negative
Charge compensation: Done

Based on the SIMS results, S/(S+Se) and Ga/(In+Ga) mole ratios were calculated, each as an average from multiple measurement sites.

Referring to FIG. 3, the depletion region of the light-absorption layer in the solar cell of Example 1, the depletion region ranging from the surface of the light-absorption layer to the depth of about 300 nm, is found to have an average S/(Se+S) mole ratio of about 0.25, and an average Ga/(In+Ga) mole ratio of about 0.08.

## Evaluation Example 3: Thermal degradation test

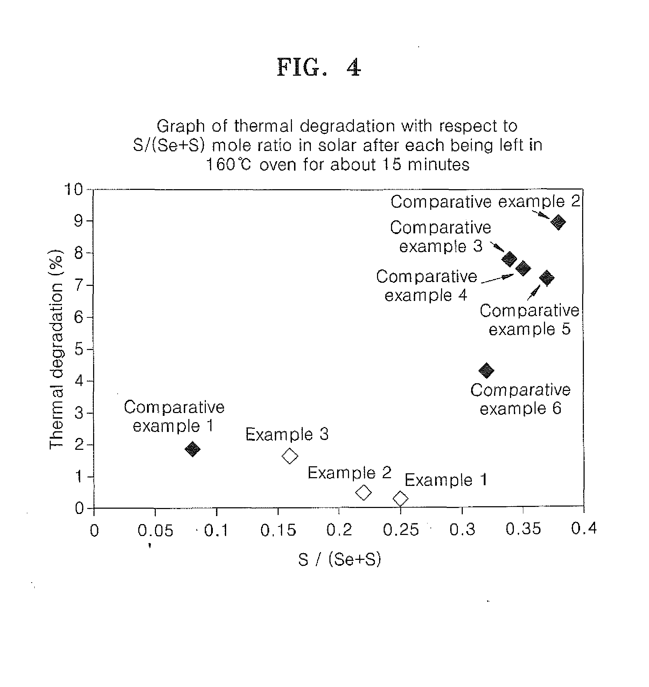

Thermal degradation test of the solar cells of Examples 1 to 3 and Comparative Examples 1 to 6 was conducted by being left in an oven at about 160°C for about 15 minutes. The results are shown in FIG. 4 and Table 1 below.

[Table 1]

| Example | S/(Se+S) mole ratio | Thermal degradation rate (%) |
| --- | --- | --- |
| Example 1 | 0.25 | 0.26 |
| Example 2 | 0.22 | 0.45 |
| Example 3 | 0.16 | 1.6 |
| Comparative Example 1 | 0.08 | 1.8 |
| Comparative Example 2 | 0.38 | 8.9 |
| Comparative Example 3 | 0.34 | 7.8 |
| Comparative Example 4 | 0.35 | 7.5 |
| Comparative Example 5 | 0.37 | 7.2 |
| Comparative Example 6 | 0.32 | 4.3 |

Referring to FIG. 4 and Table 1, the solar cells of Examples 1 to 3 were found to have lower thermal degradation rates than the solar cells of Comparative Examples 1 to 6. Although the solar cell of Comparative Example 1 had a minor difference in thermal degradation rate, i.e., about 0.2% higher, from the solar cell of Example 3, the solar cell of Comparative Example 1 had too low S/(Se+S) mole ratio as less than 0.1, and thus adhesion between the CIGS-based light-absorption layer and the rear electrode layer in the solar cell of Comparative Example 1 may be weak due to a short sulfurization time, and thus the rear electrode layer in the solar cell of Comparative Example 1 is little formed or has a very thin thickness. The CIGS-based light-absorption layer (300) may have a reduced surface energy band gap (Eg), which may lead to deterioration in open-circuit voltage ($V_{oc}$) characteristics.

## Evaluation Example 4: Admittance Spectroscopy Test

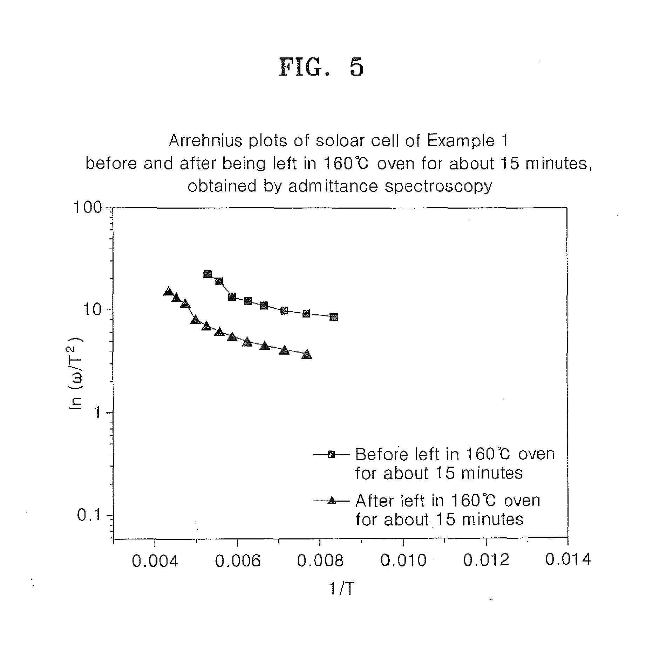

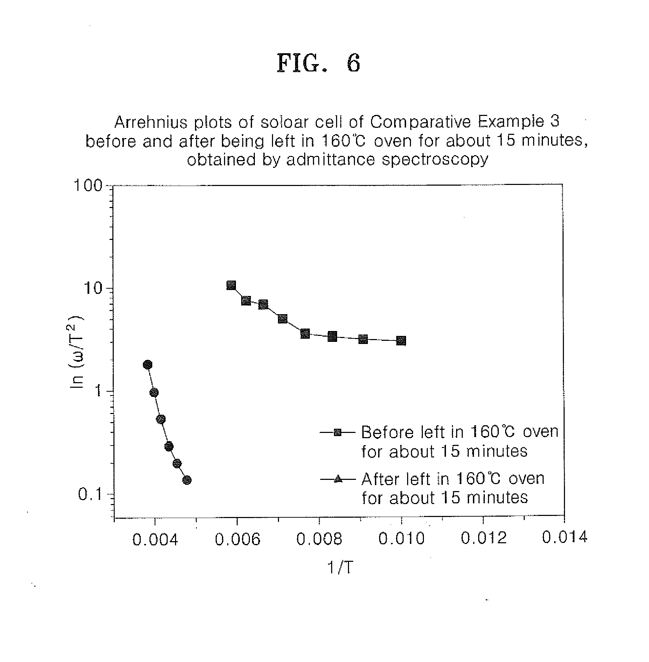

An admittance spectroscopy test of the solar cells of Example 1 and Comparative Example 3 was conducted before and after the solar cells were left in a 160°C oven for about 15 minutes to obtain Arrhenius plots of the solar cells. The results are shown in FIGS. 5 and 6 and Table 2 below.

The admittance spectroscopy test was conducted using an admittance spectrometer (B1500A, available from Agilent) in a frequency range of from 1 kHz to 1 MHz at a temperature of from about 80K to about 360K.

The Arrhenius plots were obtained using Equation 2 below, and a slope of $\ln(\omega/T^2)$ versus 1/T indicates a defect activation energy.

$$<\text{Equation 2}>$$

$$\omega = 2\varepsilon_0 T^2 \exp[- E_a /kT]$$

In Equation 2, $\omega$ is a frequency of from 1 kHz to 1 MHz, $E_a$ indicates a defect activation energy, and $\varepsilon_0$ indicates

a pre-exponential factor as a y-intercept in the graph of FIG. 5.)

[Table 2]

| Example | $E_a$(meV) before and after being left in 160°C oven for 15 min |
|---|---|
| Example 1 | 54.3, 62.3 |
| Comparative Example 3 | 49.1, 242.4 |

Referring to FIGS. 5 and 6 and Table 2, almost no change in $E_a$ before and after being left in 160°C oven for about 15 minutes was found in the solar cell of Example 1, while there was a severe change in $E_a$ before and after being left in 160°C oven for about 15 in the solar cell of Comparative Example 1.

These results indicate that the solar cell of Example 1 may maintain a relatively shallow defect depth even after the exposure to external heat as compared with the solar cell of Comparative Example 3.

While the present invention has been particularly shown and described with reference to embodiments thereof, it will be understood by those of ordinary skill in the art that various changes in form and details may be made therein without departing from the scope of the present invention as defined by the following claims.

## Claims

1. A solar cell comprising:

   a rear electrode layer disposed on a substrate; and
   a light-absorption layer disposed on the rear electrode layer and including Cu, In, Ga, Se, and S;
   wherein the light-absorption layer includes a depletion region ranging from a surface thereof to a depth t, and an average S/(Se+S) mole ratio in the depletion region is from about 0.10 to about 0.30.

2. The solar cell of claim 1, where S/(Se+S) is from about 0.12 to about 0.27, optionally from about 0.14 to about 0.25, and optionally from about 0.15 to about 0.25.

3. The solar cell of claim 1 or claim 2, wherein t is no greater than about 400 nm, optionally 25 to 350 nm, and optionally 50 to 325 nm.

4. The solar cell of any of claims 1 to 3, wherein the light-absorption layer is between 0.7 $\mu$m to about 2.5 $\mu$m in thickness, optionally 0.7 $\mu$m to about 2 $\mu$m and optionally 1.0 $\mu$m to about 2 $\mu$m.

5. The solar cell of any of claims 1 to 4, wherein depletion region is a composition represented by Formula 1 below:

   $$<\text{Formula 1}> \qquad Cu(In_{1-x}Ga_x)(Se_{1-y}S_y)_2$$

   in Formula 1,
   0. 01$\leq$ x $\leq$0.25 and 0.1$\leq$ y $\leq$0.30.

6. The solar cell of any of claims 1 to 5, wherein the solar cell also contains a buffer layer disposed on the light-absorption layer; and a transmissive electrode layer disposed on the buffer layer.

7. The solar cell of any of claims 1 to 6, wherein the solar cell is produced by a process comprising the steps of:

   preparing a substrate with a rear electrode layer thereon;
   forming a light-absorption layer including Cu, In, Ga, Se, and S on the substrate with the rear electrode layer;
   wherein the forming of the light-absorption layer comprises thermally treating a selenized metal precursor in a $H_2S$ atmosphere at a temperature of from about 500°C to about 600°C for 25 minutes to about 80 minutes, optionally about 30 minutes to about 70 minutes and optionally about 30 minutes to about 60 minutes for sulfurization.

8. The solar cell of claim 7, wherein the sulfurization step is carried out at a temperature of from about 525°C to about 575°C, optionally from about 540°C to about 560°C.

9. The solar cell of claims 7 or 8, wherein the selenized metal precursor is formed by thermally treating a metal precursor layer in a $H_2Se$ atmosphere at a temperature of from about 400°C to about 480°C for selenization, optionally from about 410°C to about 450°C, for 5 minutes to about 40 minutes, optionally about 15 minutes to about 25 minutes.

10. The solar cell of any of claims 7 to 9, wherein the forming of the metal precursor comprises sputtering, co-evaporation, electro-deposition, or molecular organic chemical vapor deposition.

11. The solar cell of claims 10, wherein the forming of the metal precursor comprises sputtering using copper (Cu), indium (In), and gallium (Ga) metal targets and/or an alloy target thereof.

12. A process for preparing a solar cell as defined in any of claims 7 to 11.

# FIG. 1

# FIG. 2

# FIG. 3

# FIG. 4

Graph of thermal degradation with respect to
S/(Se+S) mole ratio in solar after each being left in
160℃ oven for about 15 minutes

# FIG. 5

Arrehnius plots of soloar cell of Example 1
before and after being left in 160℃ oven for about 15 minutes,
obtained by admittance spectroscopy

—■— Before left in 160℃ oven
for about 15 minutes

—▲— After left in 160℃ oven
for about 15 minutes

# FIG. 6

Arrehnius plots of soloar cell of Comparative Example 3
before and after being left in 160°C oven for about 15 minutes,
obtained by admittance spectroscopy